Europäisches Patentamt

(19) European Patent Office

Office européen des brevets

(11) Veröffentlichungsnummer : **0 133 730**
**B1**

(12) **EUROPÄISCHE PATENTSCHRIFT**

(45) Veröffentlichungstag der Patentschrift :
19.07.89

(51) Int. Cl.⁴ : **H 03 C 3/06**

(21) Anmeldenummer : 84201136.3

(22) Anmeldetag : 02.08.84

(54) **Empfängerschaltung.**

(30) Priorität : 08.08.83 DE 3328555

(43) Veröffentlichungstag der Anmeldung :
06.03.85 Patentblatt 85/10

(45) Bekanntmachung des Hinweises auf die Patenterteilung : 19.07.89 Patentblatt 89/29

(84) Benannte Vertragsstaaten :
AT DE FR GB IT NL SE

(56) Entgegenhaltungen :
EP–A– 0 089 078
GB–A– 2 059 702
US–A– 3 487 326
US–A– 3 851 263
PROCEEDINGS OF THE NATIONAL ELECTRONICS
CONFERENCE, Band 24, 9.-11. Dezember 1968, Seiten
450-455, Oak Brook, US; J.F. MARCHESE et al.: "An
FMFB demodulator for satellite communications"

(73) Patentinhaber : **Philips Patentverwaltung GmbH**
**Wendenstrasse 35 Postfach 10 51 49**
**D-2000 Hamburg 1 (DE)**
**DE**
**N.V. Philips' Gloeilampenfabrieken**
**Groenewoudseweg 1**
**NL-5621 BA Eindhoven (NL)**
**FR GB IT NL SE AT**

(72) Erfinder : **Nolde, Wolfgang, Dr.**
**Im Gisterbusch 5**
**D-2000 Hamburg 61 (DE)**
Erfinder : **Kasperkovitz, Wolfdietrich, Dr.**
**Eikenlaan 4**
**Waalre (NL)**

(74) Vertreter : **Poddig, Dieter, Dipl.-Ing. et al**
**Philips Patentverwaltung GmbH Wendenstrasse 35**
**Postfach 10 51 49**
**D-2000 Hamburg 1 (DE)**

## Beschreibung

Die Erfindung betrifft eine Empfängerschaltung nach dem Oberbegriff des Hauptanspruchs. Eine solche Empfängerschaltung ist aus der DE-A-30 32 701 bekannt.

Eine derartige Empfängerschaltung ist in erster Linie zum Empfang frequenzmodulierter Signale bestimmt, obwohl damit grundsätzlich auch amplitudenmodulierte Signale empfangen werden können. Der Oszillator, der Mischer und der FrequenzSpannungswandler bilden dabei eine Schleife, deren Schleifenverstärkung in einem Nutzabstimmbereich negativ ist und deren Betrag größer als 1 (z. B. 4). Dadurch wird der Frequenzhub des Zwischenfrequenzsignals gegenüber dem Frequenzhub des Antennensignals wesentlich reduziert (bei einer negativen Schleifenverstärkung von 4 um den Faktor 5). Dies macht es möglich, die Zwischenfrequenz, die im wesentlichen durch die Auslegung des Frequenz-Spannungswandlers bestimmt ist, so niedrig zu legen (z. B. auf 70 kHz), daß zur Zwischenfrequenzselektion ein einfacher RC-Tiefpaß ausreicht. Solche Schaltungen eignen sich daher in besonderem Maße zur Herstellung in integrierter Schaltungstechnik.

Bei einer Schaltung dieser Art sind zwei stabile Abstimmbereiche gegeben, nämlich einmal der (erwünschte) Nutzabstimmbereich um die Sollfrequenz herum und zum anderen eine (unerwünschte) Abstimmung auf ein Seitenband im Bereich der Spiegelfrequenz. Diese unerwünschte Abstimmung wird bei der bekannten Schaltung mit Hilfe einer im Signalweg des demodulierten Nutzsignals angeordneten Stummschaltung unterdrückt, die durch die Steuerschaltung gesteuert wird.

Ein Nachteil der bekannten Schaltung besteht in ihrem ungewohnten Abstimmverhalten. Insbesondere ist die Abstimmung stark unsymmetrisch, d. h. die Größe des Abstimmbereiches und seine Lage in bezug auf die Sollfrequenz hängen stark davon ab, ob beim Abstimmen von einer höheren oder von einer niedrigeren Frequenz ausgegangen wird. Ungewohnt ist ferner, daß beim Empfang von FM-Signalen Abstimmungen möglich sind, bei denen kein Ausgangssignal und praktisch auch kein Rauschen vorhanden ist. Dieses Verhalten kann den nicht geschulten Benutzer eines solchen Empfängers verwirren, weil er es von herkömmlichen Empfängern nicht kennt.

Aufgabe der vorliegenden Erfindung ist es, eine Empfängerschaltung der eingangs genannten Art so auszugestalten, daß sich trotz niedriger Zwischenfrequenz ein weitgehend symmetrisches Abstimmverhalten ergibt.

Diese Aufgabe wird durch die im Kennzeichen des Hauptanspruchs angegebenen Maßnahmen gelöst.

Bei Abstimmung auf den erwünschten Abstimmbereich um die Sollfrequenz herum bleibt die Schleifenverstärkung unverändert, so daß die Hubkompression und die sonstigen vorteilhaften Eigenschaften der Schaltung in diesem Bereich erhalten bleiben. Bei stärkeren Verstimmungen ist die Schleifenverstärkung jedoch herabgesetzt, wodurch sich ein symmetrisches Abstimmverhalten ergibt. Indes ist die Herabsetzung kleiner als der Maximalwert der Verstärkung.

Es sei an dieser Stelle erwähnt, daß aus der US-A-3,851,263 bereits ein FM-Empfänger mit einer automatischen Frequenznachstimmung bekannt ist, der einen Oszillator enthält, dessen Frequenz durch eine Steuergleichspannung an einem Steuereingang steuerbar ist, eine Mischstufe, die das Oszillatorsignal mit einem Antennensignal mischt und daraus ein ZF-Signal bildet, und einen Frequenz-Spannungswandler, dem das ZF-Signal zugeführt wird und aus dessen Ausgangssignal die Steuergleichspannung für den Steuereingang des Oszillators abgeleitet wird. Zwischen den Frequenz-Spannungswandler und die Mischstufe ist dabei ein Begrenzer geschaltet, der in Abhängigkeit vom Ausgangssignal des Frequenz-Spannungswandlers so gesteuert ist, daß der Begrenzerpegel maximal ist, wenn das ZF-Signal mit der Mitte der Frequenzcharakteristik des Frequenz-Spannungswandlers übereinstimmt, und daß der Begrenzerpegel mit zunehmender Verstimmung abnimmt. Zusätzlich ist ein Detektor vorgesehen, dem das Eingangssignal des Begrenzers zugeführt wird· und der den Begrenzerpegel auf Null setzt, wenn die Amplitude des ZF-Signals einen bestimmten Wert überschreitet. Dadurch soll bei großer Fehlabstimmung eine Stummschaltung erfolgen.

Die Probleme, die der Erfindung zugrunde liegen (unsymmetrisches Abstimmverhalten) treten bei der bekannten Schaltung nicht auf, und die dort angegebenen Lösungen sind zur Lösung dieser Probleme nicht geeignet.

Eine Weiterbildung der Erfindung sieht vor, daß die Steuerschaltung als Korrelator ausgebildet ist, wobei die Korrelationszeit einer halben Periode des Sollwertes der Zwischenfrequenz entspricht. Ein Korrelator ist bekanntlich eine Schaltung, in der der zeitliche Mittelwert des Produktes einer Schwingung mit der um die Korrelationszeit verzögerten Schwingung gebildet wird, wobei die Korrelationszeit in diesem Fall einer halben Periode der Sollfrequenz entspricht, d. h. bei der Sollfrequenz haben die zu multiplizierenden Signale gerade eine Phasenverschiebung von 180°.

Das Dämpfungsglied kann durch das Steuersignal der Steuerschaltung schaltend (sprungartig) gesteuert werden, jedoch auch analog (kontinuierlich). Das Dämpfungsglied selbst kann unmittelbar in die Schleife aufgenommen sein, so daß die Schleife über· das Dämpfungsglied geschlossen wird, dessen Verstärkung bzw. Dämpfung dann durch die Steuerschaltung gesteuert wird. Demgegenüber sieht jedoch eine bevorzugte Weiterbildung der Erfindung vor, daß der Frequenz-Spannungswandler eine Multiplizierschaltung enthält, deren Wirkungsgrad durch die Steuerschaltung gesteuert ist. Das Dämpfungsglied liegt hier also nicht unmittelbar in der Schleife, sondern beeinflußt lediglich den Wirkungsgrad eines in der Schleife enthaltenen Gliedes. Durch diese Ausgestaltung ergibt sich ein besonders niedriger zusätzlicher Aufwand.

Eine Verringerung des Aufwandes ergibt sich nach einer Weiterbildung der Erfindung auch dadurch, daß eine Unterdruckungsschaltung zum vollständigen oder teilweisen Unterdrücken der Wiedergabe des aus dem Antennensignal abgeleiteten Nutzsignals vorgesehen ist und daß die Steuerschaltung außer der Dampfungsschaltung die Unterdruckungsschaltung steuert derart, daß die Unterdruckungsschaltung aktiviert wird, wenn die Zwischenfrequenz um einen vorbestimmten Betrag von der Sollfrequenz abweicht. Die Unterdrükkungsschaltung und die sie steuernde Steuerschaltung sind auch schon bei der bekannten Empfängerschaltung vorgesehen. Als zusätzlicher Aufwand kommt bei der Erfindung im wesentlichen also nur das Dämpfungsglied hinzu.

Die Erfindung wird nachstehend anhand der Zeichnung näher erläutert. Es zeigen

Fig. 1 ein Blockschaltbild der bekannten Empfängerschaltung,

Fig. 2a bis 2e verschiedene Diagramme, aus denen sich das Abstimmverhalten der Schaltung nach Fig. 1 ergibt,

Fig. 3 ein Blockschaltbild der erfindungsgemäßen Schaltung,

Fig. 4 verschiedene Diagramme, aus denen sich das Abstimmverhalten der Schaltung nach Fig. 3 ergibt,

Fig. 5 eine besonders einfache Ausführungsform eines Dämpfungsgliedes in Kombination mit einem Frequenz-Spannungswandler,

Fig. 6a eine andere Ausführungsform einer Steuerschaltung, und

·Fig. 6b und 6c die sich dabei ergebenden Spannungsverläufe.

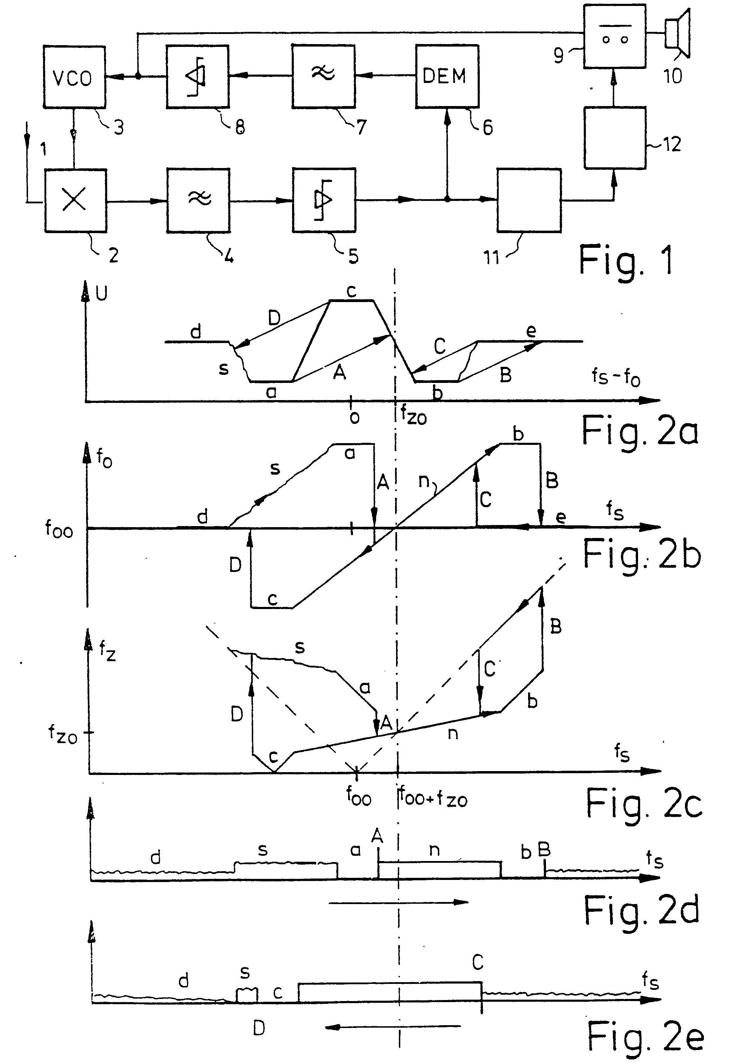

In Fig. 1 ist das Blockschaltbild eines bekannten UKW-Empfängers dargestellt. Mit 1 ist dabei eine Antenne bezeichnet, deren Signal einem Mischer 2 zugeführt wird, in dem es mit dem Signal eines Oszillators 3 gemischt wird, dessen Frequenz durch eine Spannung linear steuerbar ist und der auf die übliche Weise, z. B. mittels eines Drehkondensators, abgestimmt werden kann. Das von dem Mischer 2 erzeugte Zwischenfrequenzsignal wird einem Tiefpaß 4 zugeführt, dessen Grenzfrequenz etwa 100 kHz beträgt, so daß dadurch Signale von benachbarten Sendern und erst recht Mischprodukte mit der Summenfrequenz des Antennen- und des Oszillatorsignals unterdrückt werden. Der Ausgang des Tiefpaßfilters 4 ist mit einem Begrenzer-Verstärker 5 verbunden, dessen Ausgangssignal wiederum einem als Frequenz-Spannungswandler dienenden Frequenz-Demodulator 6 zugeführt wird. Der Frequenz-Spannungswandler ist für eine Zwischenfrequenz $f_{zo}$ von z. B. 70 kHz ausgelegt, d. h. das Demodulator-Ausgangssignal ist für diese Frequenz Null und ändert sich annähernd linear mit der Abweichung der Zwischenfrequenz von diesem (Soll-)Wert. Das Ausgangssignal des FM-Demodulators 6 wird einem Tiefpaß 7 zugeführt, der für die Stabilisierung der Schleife benutzt wird und dessen Grenzfrequenz niedriger liegt als die des Nutzsignals. Der Ausgang des Tiefpaßfilters 7 ist mit dem Eingang eines Begrenzer-Verstärkers 8 verbunden, dessen Ausgang das Signal entnommen wird und der gleichzeitig mit dem Steuereingang des spannungsgesteuerten Oszillators verbunden ist, so daß die Oszillatorfrequenz im Takte der Amplitude des Audiosignals geändert wird. Das Audiosignal wird über einen Stummschalter 9 und gegebenenfalls einen nicht näher dargestellten Verstärker einer Wiedergabeeinheit 10, z. B. einem Lautsprecher, zugeführt. Die Stummschaltung 9 wird von einer Steuerschaltung 11 mit einer relativ großen Zeitkonstante über eine geeignete Umformstufe 12, beispielsweise einem Verstärker mit sehr hoher Verstärkung, gesteuert, und zwar derart, daß die Wiedergabe gedämpft bzw. unterdrückt wird, wenn die Zwischenfrequenz um einen bestimmten Betrag von dem Wert $f_{zo}$ abweicht. Die Steuerschaltung kann den gleichen Aufbau haben wie der Korrelator bei der Schaltung nach der DE-A-30 32 701. Insbesondere können der Demodulator 6 und die Steuerschaltung 11. ebenso wie bei dem bekannten Empfänger — einen Teil der Phasendrehglieder gemeinsam haben.

Zur Erläuterung der Wirkung der Schaltung nach Fig. 1 wird nachstehend auf die Fig. 2a bis 2e Bezug genommen. In Fig. 2a ist die Ausgangsspannung U des Begrenzer-Verstärkers 8 als Funktion der Differenz zwischen der Senderfrequenz $f_s$ und der Oszillatorfrequenz $f_o$ dargestellt, wobei angenommen ist, daß die Schleife vor dem Steuereingang des Oszillators unterbrochen ist. Diese Kennlinie ist symmetrisch zum Punkt $f_s = f_o$ ($f_s - f_o = 0$). Die Kurve enthält außen, d. h. für Differenzfrequenzen, die einen bestimmten Betrag überschreiten, horizontal verlaufende Bereiche d und e, in denen die Ausgangsspannung des Begrenzer-Verstärkers U unabhängig von der Differenz zwischen Sender- und Oszillatorfrequenz ist. Die Lage dieser Bereiche, d. h. ihr Frequenzabstand wird durch die Auslegung des Tiefpasses 4 (Fig. 1) bestimmt: Je höher dessen Grenzfrequenz ist, um so größer ist der Abstand zwischen diesen beiden Kurvenabschnitten. Dazwischen, d. h. bei niedrigere Differenzfrequenzen, liegen noch weitere horizontal verlaufende Kurvenabschnitte, nämlich die Abschnitte a, b und c. Diese werden durch den Begrenzer 8 erzeugt. Da in diesen Abschnitten die Änderung der Differenz zwischen Sender- und Oszillatorfrequenz keinen Einfluß auf die Ausgangsspannung und damit auf die Frequenz des Oszillators 3 hat, ist hier (bei geschlossener Schleife) die Schleifenverstärkung Null. Wenn darüber hinaus in den Bereichen a, b oder c ein frequenzmoduliertes Signal empfangen wird, wird dadurch einerseits das Rauschen unterdrückt und andererseits wird am Lautsprecher 10 kein Signal hörbar, weil die Frequenzmodulation, d. h. die Änderung des Momentanwertes der Senderfrequenz entsprechend dem Momentanwert des Signals, keinen Einfluß auf die Ausgangsspannung hat.

Weiterhin enthält die Kurve zwei Bereiche mit negativer Steigung, in denen also mit wachsender Zwischenfrequenz die Ausgangsspannung U abnimmt. Dies sind die Bereiche s und der um die Sollfrequenz $f_{zo}$ liegende Bereich, in dem die Senderfrequenz größer ist als die Oszillatorfrequenz. Es sei angenommen, daß die (geschlossene) Schleife so ausgelegt ist, daß sich bei dieser negativen Steigung eine negative Schleifenverstärkung ergibt, und zwar derart, daß die Schleifenverstärkung um die Frequenz $f_{zo}$ herum kleiner ist als -1, z. B. -4. Dann bedeutet dies, daß jede Änderung des Momentanwertes der Senderfrequenz, d. h. jede Frequenzmodulation, eine Änderung der Begrenzer-Ausgangsspannung U und damit der Oszillatorfrequenz fo zur Folge hat derart, daß die Differenz zwischen dem Momentanwert der Senderfrequenz und dem Momentanwert der Oszillatorfrequenz verringert wird, was gleichbedeutend damit ist, daß der Frequenzhub des Zwischenfrequenzsignals am Ausgang des Mischers 2 kleiner ist als der Frequenzhub des Sendersignals. Bei einer Schleifenverstärkung von -4 wird der Frequenzhub also um den Faktor 5 verringert. Aus diesem Grunde ist es möglich, mit einer derartigen Schaltung, bei der die Zwischenfrequenz einen Sollwert $F_{zo}$ von nur 70 kHz hat, ein UKWSignal zu empfangen, dessen Frequenzhub bekanntlich 75 kHz beträgt, ohne daß sich nichtlineare Verzerrungen aufgrund der Bandbegrenzung ergeben.

Da die Ausgangsspannung U als Funktion der Differenz $f_s-f_o$ symmetrisch zur Geraden $f_s = f_o$ verläuft, weist die Kurve auch zwei Bereiche mit positiver Steigung auf. Der Bereich, in dem die Senderfrequenz um den Wert $f_{zo}$ kleiner ist als die Oszillatorfrequenz, hat dann in dem angenommenen Beispiel (bei geschlossener Schleife) eine Schleifenverstärkung von +4. Das bedeutet, daß eine Abstimmung auf einen dieser Bereiche mit positiver Schleifenverstärkung, die dem Betrage nach größer ist als 1, nicht möglich ist, weil die Schleife hier instabil ist, so daß diese Bereiche beim Durchstimmen übersprungen werden, wie noch später gezeigt wird.

Aus den Fig. 2b bis 2d ergibt sich nun das Verhalten des Empfängers bei geschlossener Schleife als Funktion der Senderfrequenz $f_s$, wobei der Einfachheit halber angenommen ist, daß bei Abstimmung auf die Bereiche d und e die Oszillatorfrequenz $f_o$ den konstanten Wert $f_{oo}$ hat und daß lediglich die unmodulierte Trägerfrequenz $f_s$ des Senders moduliert wird. Aus Fig. 2b, die die Abhängigkeit der Oszillatorfrequenz $f_o$ von $f_s$ zeigt, erkennt man dann, daß im Bereich d, bei dem die Senderfrequenz genügend weit unterhalb der Oszillatorfrequenz $f_{oo}$ ist, eine Vergrößerung der Senderfrequenz keinen Einfluß auf die Oszillatorfrequenz hat. Fig. 2c, die die Abhängigkeit der Zwischenfrequenz von der Senderfrequenz darstellt, zeigt, daß deshalb die Zwischenfrequenz jeweils um den gleichen Betrag abnimmt, um den die Senderfrequenz zunimmt, so daß sich in diesem Bereich eine gestrichelt angedeutete Gerade mit einem Steigungswinkel von − 45° ergibt. Aus Fig. 2d, die die Art des Nutzsignals am Eingang der Stummschaltung 9 als Funktion der Senderfrequenz $f_s$ bei zunehmender Senderfrequenz charakterisiert, ergibt sich, daß in diesem Bereich d nur ein Rauschen empfangen werden kann.

Dieser Bereich endet, wenn die Senderfrequenz so weit zugenommen hat, daß die (negative) Differenz zwischen der Senderfrequenz und der Oszillatorspannung $f_{oo}$ so weit abgenommen hat, daß die resultierende Differenzfrequenz vom Tiefpaßfilter 4 durchgelassen wird. Die Abstimmung gelangt dann in den Bereich s, in dem die oszillatorfrequenz $f_o$ mit der Senderfrequenz zunimmt (Fig. 2b), aufgrund der endlichen Schleifenverstärkung jedoch nicht in gleichem Maße wie die Senderfrequenz $f_s$. Infolgedessen ergibt sich hier noch eine — allerdings verringerte — Abnahme der Zwischenfrequenz (Fig. 2c). In diesem Bereich, in dem also auf eine Flanke des Tiefpasses abgestimmt ist, ergibt sich eine Demodulation des Eingangssignals, aber schlechtere Signal/Rauschverhältnisse.

Wenn auf diese Weise diejenige Oszillatorfrequenz erreicht ist, die auf der die Oszillatorfrequenz steuernden Spannung U dem Niveau a entspricht, ändert sich die Oszillatorfrequenz mit steigender Senderfrequenz zunächst nicht mehr (Fig. 2b), so daß die Zwischenfrequenz wiederum um den gleichen Betrag abnimmt, um den die Senderfrequenz zunimmt (Fig. 2c). Wie erläutert, ergibt sich in diesem Bereich jedoch kein Ausgangssignal, und zwar selbst dann nicht, wenn das Sendersignal frequenzmoduliert ist.

Wenn dieser Bereich durchlaufen ist, folgt der Bereich mit positiver Schleifenverstärkung, der wie erwähnt nicht stabil ist. Infolgedessen ändert sich hier das Oszillatorsignal sprungartig mit der Senderfrequenz (Fig. 2b Sprung A) und ebenso die Zwischenfrequenz (Fig. 2c). Dabei wird nicht nur der gesamte Bereich mit positiver Schleifenverstärkung übersprungen, sondern auch der Bereich c und sogar ein Teil des Nutzabstimmbereiches n um die Frequenz herum, bei der die Senderfrequenz gleich der Summe aus der konstanten Oszillatorfrequenz $f_{oo}$ und dem Sollwert der Zwischenfrequenz $f_{zo}$ ist. Dieser Sprung A ist um so größer, je größer die Schleifenverstärkung ist. Bei großer Schleifenverstärkung kann dabei sogar die perfekte Sendeabstimmung ($f_s = f_{oo} + f_{zo}$) übersprungen werden. Nach diesem Sprung, durch den der Bereich n mit negativer Schleifenverstärkung erreicht wird, ändert sich die Oszillatorfrequenz $f_o$ wiederum mit der Senderfrequenz, aufgrund der endlichen Schleifenverstärkung jedoch weniger stark als diese, wobei die Oszillatorfrequenz bei der Senderfrequenz $f_s = f_{oo} + f_{zo}$ wiederum den Wert $f_{oo}$ erreicht und danach weiter im wesentlichen linear ansteigt. In diesem Nutzabstimmbereich wird jede Änderung der Senderfrequenz in eine Änderung der Ausgangsspannung am Begrenzerverstärker 8 umgesetzt, d. h.

ein frequenzmoduliertes Signal wird demoduliert.

Dieser Bereich endet, wenn die Senderfrequenz soviel größer geworden ist als die Oszillatorfrequenz, daß der Bereich b erreicht wird. In diesem Bereich ändert sich die Oszillatorfrequenz nicht mehr (Fig. 2b), die Zwischenfrequenz $f_z$ steigt im gleichen Maße an wie die Senderfrequenz $f_s$ (Fig. 2c), und am Eingang der Stummschaltung 9 ist kein Signal zu empfangen (Fig. 2d). Auf diesen Bereich folgt wiederum ein Bereich mit positiver Schleifenverstärkung, in dem sich die Oszillatorfrequenz $f_o$ bzw. die Zwischenfrequenz $f_z$ sprungartig schon bei einer sehr kleinen Änderung der Senderfrequenz (bzw. — wenn von der Annahme, daß sich die Senderfrequenz $f_s$ ändert und die Grundabstimmung $f_{oo}$ konstant bleibt, abgesehen wird — bei einer sehr kleinen Abnahme der Grundabstimmung $f_{oo}$), wobei wiederum ein Teil des horizontal verlaufenden Bereiches e übersprungen wird, bis die Grundabstimmung erreicht ist. Bei noch weiter zunehmender Senderfrequenz ändert sich dann an der Oszillatorfrequenz nichts mehr und am Eingang der Stummschaltung 9 tritt ein Rauschsignal auf.

Wird statt dessen die Senderfrequenz von größeren Werten ausgehend erniedrigt, ergibt sich ein ganz anderes Abstimmverhalten. Zunächst wird wiederum der Bereich e durchlaufen — allerdings bis zu seinem Ende — wobei die Oszillatorfrequenz konstant bleibt ($f_{oo}$), während die Zwischenfrequenz mit der Senderfrequenz abnimmt. Am Eingang der Stummschaltung 9 erscheint ein Rauschsignal (Fig. 2e). Dieser Bereich endet, wenn der durch die Flanken des Tiefpasses 4 bestimmte Bereich mit positiver Schleifenverstärkung erreicht wird. Es folgt dann ein Sprung C der Oszillatorfrequenz bzw. der Zwischenfrequenz, wobei der Bereich B (Fig. 2a) ganz und der Nutzabstimmbereich n zu einem kleinen Teil übersprungen wird. Von da an folgt die Oszillatorfrequenz $f_o$ der Senderfrequenz auf der Linie n (Fig. 2b), wobei die Zwischenfrequenz geringfügig abnimmt (Fig. 2c), bis der gesamte Abstimmbereich n durchlaufen wird und der Teil c folgt, in dem sich die Oszillatorfrequenz nicht mehr ändert (Fig. 2b), in dem die Zwischenfrequenz zunächst in gleichem Maße abnimmt wie die Senderfrequenz, danach jedoch in entgegengesetztem Sinn wieder ansteigt, und in dem am Eingang der Stummschaltung kein Signal erscheint (Fig. 2e), bis schließlich der Beginn des Kurventeiles mit positiver Schleifenverstärkung erreicht ist.

Bei weiterer Vergrößerung überspringt dann die Abstimmung diesen Bereich, den daran anschließenden Bereich a und einen großen Teil des darauffolgenden Bereiches mit negativer Schleifenverstärkung, wonach nur noch der kleine restliche Teil des durch die Filterflanken bestimmten Abstimmbereiches s durchlaufen wird, dem dann der Bereich d folgt, in dem die Grundabstimmung $f_{oo}$ erreicht ist, wonach sich keine weitere Änderung der Oszillatorfrequenz $f_o$ ergibt (Fig. 2b) und der Stummschaltung 9 nur noch ein Rauschsignal zugeführt wird (Fig. 2e).

Wie ein Vergleich der Fig. 2d und 2e zeigt, hängt das Abstimmverhalten wesentlich davon ab, in welcher Richtung der Abstimmbereich durchlaufen wird. Man erkennt, daß der Nutzabstimmbereich n bei Fig. 2d stark unsymmetrisch zur exakten Abstimmfrequenz $f_s = f_{oo} + f_{zo}$ liegt. Die Stummabstimmbereiche a, b und c verwirren den Benutzer. Die von der Steuerschaltung 11 gesteuerte Stummschaltung 9 kann die beschriebenen Effekte nur zum Teil unterdrücken und beeinflußt das unsymmetrische Abstimmverhalten nicht.

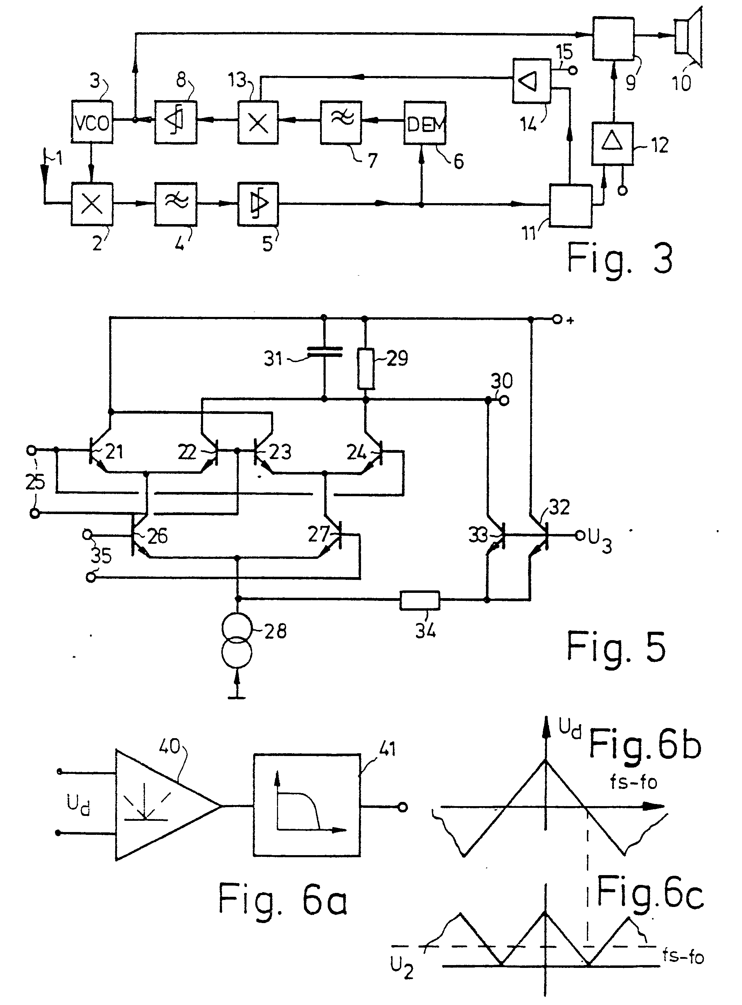

Die in Fig. 3 dargestellte erfindungsgemäße Schaltung unterscheidet sich von der bekannten Schaltung dadurch, daß zwischen den Ausgang des Tiefpasses 7, der dem FM-Demodulator folgt, und den Eingang des den Oszillator 3 in seiner Frequenz steuernden Begrenzer-Verstärkers 8 ein Dämpfungsglied 13 geschaltet ist, das von der Steuerschaltung 11 über einen Verstärker 14 gesteuert wird. Im übrigen enthält die Schaltung die gleichen Bauelemente, weshalb hier wie da dieselben Bezugszeichen verwendet sind. Allerdings muß, wenn die durch die Steuerschaltung 11 bzw. den Verstärker 14 herabsetzbare Grunddämpfung bzw. Grundverstärkung des Dämpfungsgliedes 13 von dem Wert 1 abweicht, der Übertragungsfaktor der anderen Bauelemente so bemessen werden, daß sich etwa die gleiche Schleifenverstärkung ergibt, wie bei der Schaltung nach Fig. 1.

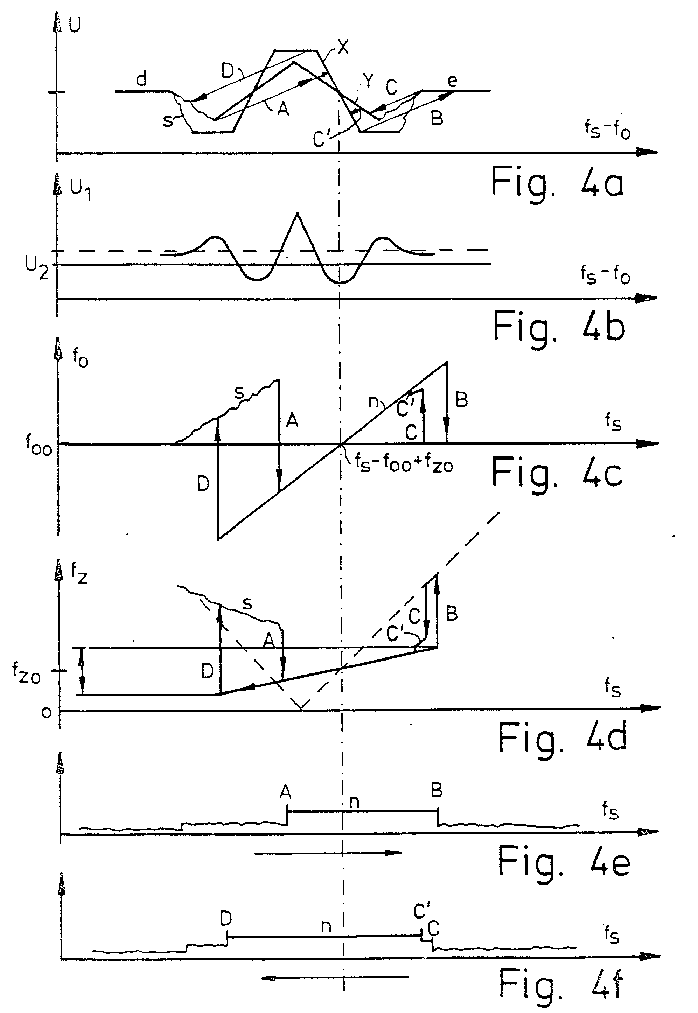

Infolgedessen hat bei geöffneter Schleife das Ausgangssignal U als Funktion der Differenz zwischen der Senderfrequenz und der Oszillatorfrequenz den gleichen Verlauf wie bei Fig. 2a, wenn das Dämpfungsglied unwirksam ist bzw. nur seine Grunddämpfung (-) Verstärkung wirksam ist — vgl. Fig. 4a, Kurve x. Wenn hingegen das Dämpfungsglied eingeschaltet ist und seine Dämpfung voll wirksam ist, wird seine Verstärkung so weit herabgesetzt, daß eine Begrenzung nicht mehr stattfindet — vgl. Fig. 4a, Kurve y. Die Vergrößerung der Dämpfung bzw. die Verringerung der Verstärkung darf jedoch nur so groß sein, daß die Schleifenverstärkung in dem Nutzabstimmbereich n und in den dazu spiegelbildlichen Bereich dem Betrage nach größer als 1 bleibt, denn nur dann ist ausgeschlossen, daß eine Abstimmung auf einen Bereich mit positiver Schleifenverstärkung erfolgen kann.

In Fig. 4b ist der Verlauf der Ausgangsspannung $U_1$ der Steuerschaltung 11 als Funktion der Differenz zwischen Senderfrequenz $f_s$ und Oszillatorfrequenz $f_o$ dargestellt. Die Steuerschaltung kann ebenso wie die bekannte Schaltung ein Korrelator sein, der einen Tiefpaß umfaßt, der den Mittelwert der Ausgangsspannung eines Multiplizierers integriert, dessen einem Eingang das Zwischenfrequenzsignal hinter dem Ausgang des Begrenzer-Verstärkers 5 direkt und dessen anderem Eingang dieses Signal mit einer linear von der Frequenz abhängenden Phasendrehung zugeführt wird, wobei die Phasendrehung bei dem Sollwert der Zwischenfrequenz $f_{zo}$ gerade 180° beträgt. Es ergibt sich dann eine zur Geraden $f_s = f_o$ symme-

trische Kennlinie, die ihre Minima in den Bereichen hat, in denen der Betrag der Differenzfrequenz gleich $f_{zo}$ ist. Die Ausgangsspannung $U_1$ wird durch den Verstärker 14 verstärkt und mit der Spannung an dessen Referenzeingang 15 verglichen und die Differenz verstärkt in einem Bereich um den Sollwert $f_{zo}$, dessen Größe durch die Wahl der Spannung $U_2$ (vgl. Fig. 4b, gestrichelte und ausgezogene Gerade) am Referenzeingang 15 des Verstärkers abhängig ist, ergibt sich dadurch eine Steuerspannung, die die Schleifenverstärkung auf ihren Grundwert beläßt, während sie in den außerhalb liegenden Bereichen der Zwischenfrequenz herabgesetzt wird. Dadurch wird das Abstimmverhalten der Schaltung wesentlich geändert, wie sich aus den Fig. 4c bis 4e ergibt.

In Fig. 4c ist der Verlauf der Oszillatorfrequenz $f_o$ als Funktion der Senderfrequenz $f_s$ dargestellt, wobei wiederum die Annahme zugrunde liegt, daß die Grundabstimmung $f_{oo}$ des Oszillators konstant gehalten wird, während die Senderfrequenz $f_s$ geändert wird. Bei relativ kleinen Senderfrequenzen ändert sich die Grundabstimmung zunächst nicht, bis der Bereich s erreicht ist. In diesem Bereich bzw. — je nach Lage der Referenzspannung $U_2$ — in einem Teil dieses Bereiches überschreitet die Ausgangsspannung $U_1$ der Steuerschaltung 11 den Referenzwert $U_2$, so daß das Dämpfungsglied eingeschaltet ist und die Schleifenverstärkung herabgesetzt ist. Infolgedessen folgt die Oszillatorfrequenz hier zwar auch der Senderfrequenz (Fig. 4c), jedoch nicht im gleichen Maße wie bei der Schaltung nach Fig. 1 (vgl. Fig. 2c), bis ein niedrigerer Wert erreicht ist, der dem Minimum der Kurve y (Fig. 4a) entspricht.

Darauf folgt bereits der Bereich mit positiver Schleifenverstärkung, der, da die Schleifenverstärkung auch bei wirksamem Dämpfungsglied größer ist als 1, zu einem Frequenzsprung A führt, der im Nutzabstimmbereich n endet. Obwohl in diesem Nutzabstimmbereich die Ausgangsspannung $U_1$ der Steuerschaltung 11 unterhalb der Referenzspannung $U_2$ liegen müßte, was zur Folge hätte, daß das Dämpfungsglied unwirksam wäre und die volle Schleifenverstärkung vorhanden wäre, ist das Dämpfungsglied zunächst doch noch wirksam, weil die Spannung $U_1$ aufgrund der relativ großen Zeitkonstanten der Steuerschaltung 11 (0,1 sec oder länger) sich nur relativ langsam ändert. Das bedeutet, daß die Schleifenverstärkung allmählich größer wird, was eine weitere Zunahme der Oszillatorfrequenz zur Folge hat, ohne daß sich die Senderfrequenz ändert, bis schließlich das ausgeschaltet und die volle Schleifenverstärkung vorhanden ist. Es wird dann der Abstimmbereich n durchlaufen, an dessen Ende die Oszillatorfrequenz sich wieder sprungartig ändert (Sprung B), bis der Wert $f_{oo}$ erreicht ist. Danach ist die Oszillatorfrequenz von der Senderfrequenz unabhängig.

Das Verhalten des Signals am Eingang der Stummschaltung 9 als Funktion der Senderfrequenz ergibt sich aus Fig. 4e. Man erkennt daraus, daß der Nutzabstimmbereich n annähernd symmetrisch zu der Senderfrequenz liegt, bei der die exakte Abstimmung erreicht wird.

Wird der Abstimmbereich stattdessen von höheren Senderfrequenzen $f_s$ ausgehend durchlaufen, ist zunächst das Dämpfungsglied voll wirksam, so daß die Kurve y das Verhalten der Schaltung bestimmt. Wenn die Senderfrequenz so niedrig ist, daß das resultierende Zwischenfrequenzsignal wenigstens zum Teil von dem Tiefpaß durchgelassen wird und somit ein Teil mit positiver Schleifenverstärkung erreicht wird, ergibt sich wiederum ein Sprung C in den Nutzabstimmbereich n, wobei die Abschwächung jedoch noch immer wirksam ist. Erst wenn die Senderfrequenz so weit verringert ist, daß das Signal $U_1$ das Signal $U_2$ unterschreitet (Fig. 4b), wird die volle Schleifenverstärkung wirksam und es erfolgt ein erneuter Frequenzsprung C' Danach wird wieder der restliche Teil des Abstimmbereiches durchlaufen, bis die Differenz zwischen der Senderfrequenz und der Oszillatorfrequenz so groß geworden ist, daß die Spannung $U_1$ die Referenzspannung $U_2$ wieder überschreitet und die Dämpfung des Dämpfungsgliedes wirksam ist. Es erfolgt dann ein Sprung D (Fig. 4a und 4c), bis der Bereich s erreicht wird, auf dem die Oszillatorfrequenz allmählich wieder auf den Grundwert $f_{oo}$ abnimmt. Das resultierende Abstimmverhalten als Funktion der Senderfrequenz zeigt Fig. 4f. Man erkennt, daß der Bereich c (vgl. Fig. 2e), dem kein Signal der Stummschaltung 9 erreicht, entfallen ist, ebenso wie die Bereiche a und b nicht mehr auftreten (vgl. Fig. 2d und Fig. 4e).

Durch die Steuerung der Schleifenverstärkung in Abhängigkeit von der Zwischenfrequenz ist es also gelungen, das Abstimmverhalten der Schaltung entscheidend zu verbessern. Die noch verbliebenen Störungen (Frequenzsprünge A...D, Seitenabstimmung s und Rauschen d, e) können wie bei der bekannten Schaltung nach der DE-A-30 32 701 durch die Stummschaltung unterdrückt werden. Dabei ist es nicht erforderlich, daß die Stummschaltung das Signal völlig unterdrückt, sondern es genügt, wenn das Signal wesentlich gedämpft wird. Ebenso kann wie bei der bekannten Schaltung auf einen künstlichen Rauschgenerator umgeschaltet werden, wenn die Zwischenfrequenz um einen bestimmten Betrag von ihrem Sollwert $f_{zo}$ abweicht.

Es ist nicht unbedingt erforderlich, daß das Dämpfungsglied zwischen dem Begrenzer-Verstärker 8 und dem Tiefpaß 7 angeordnet ist. Es muß lediglich so angeordnet sein, daß die Schleifenverstärkung dadurch beeinflußt werden kann. Ebenso ist es nicht erforderlich, daß das Signal in der Schleife über das Dämpfungsglied geführt wird. Es genügt vielmehr, wenn der Wirkungsgrad einer der Schaltungen, z. B. des FM-Demodulators 6, durch das Dämpfungsglied gesteuert wird, so daß sich damit die Schleifenverstärkung ändert. Ein Beispiel für einen solchen FM-Demodulator ist in Fig. 5 dargestellt.

Es handelt sich dabei um einen sogenannten Quadratur-Demodulator, der vier Transistoren 21...24 umfaßt, die als kreuzgekoppelte Differenz-Verstärker geschaltet sind, bei denen also jeder Transistor mit jedem der drei übrigen Transistoren eine Elektrode — und nur diese eine — gemeinsam hat. Die Eingangsspannung, d. h. das Zwischenfrequenzsignal, wird dieser Schaltung zwischen den miteinander verbundenen Basen der Transistoren 21 und 24 einerseits und der Transistoren 22 und 23 andererseits an den Klemmen 25 zugeführt. Die Emitterströme für die Transistoren 21 und 22 sowie 23 und 24 werden von je einem Transistor 26 bzw. 27 geliefert, deren Emitter ebenfalls miteinander verbunden sind und deren mit dem zweiten Eingang 35 verbundenen Basis-Elektroden ebenfalls das Zwischenfrequenzsignal — jedoch mit einer linear von der Zwischenfrequenz abhängenden Phasendrehung zugeführt wird, wobei die Phasendrehung bei der dem Sollwert $f_{zo}$ der Zwischenfrequenz gerade 90° beträgt. In die gemeinsame Emitterzuleitung der Transistoren 26 und 27 ist eine Gleichstromquelle 28 eingeschaltet. Die den Eingangsklemmen 25 und 35 zugeführten Eingangsspannungen werden durch die aus den Transistoren 21...27 und der Gleichstromquelle 28 bestehende Schaltung moduliert, so daß an den miteinander verbundenen Kollektoren der Transistoren 22 und 24 ein Kollektor-Signalstrom auftritt, der dem Produkt der zwischenfrequenten Eingangssignale proportional ist. Der Kollektor-Signalstrom erzeugt an einem zwischen die genannten Kollektoren und ·eine positive· Versorgungsspannungsklemme geschalteten Widerstand 29 eine Signal spannung, die am Ausgang 30 abnehmbar ist. Ein Kondensator 31, der dem Widerstand 29 parallelgeschaltet ist, wirkt zusammen mit diesem Widerstand als Tiefpaß, so daß bei geeigneter Bemessung der Zeitkonstante des RC-Gliedes 29, 31 ein gesonderter Tiefpaß 7 nicht erforderlich ist.

Bei diesem Demodulator ist die Amplitude des Ausgangssignals auch von dem Gleichstrom der Gleichstromquelle 28 abhängig, und zwar ist sie um so größer, je größer dieser Gleichstrom ist. Der Wirkungsgrad eines solchen Demodulators läßt sich daher dadurch verringern, daß ein Teil des Gleichstromes abgezweigt wird. Diesem Zweck dienen die beiden Transistoren 32 und 33, deren Emitteranschlüsse miteinander und über einen Widerstand 34 mit den Emitteranschlüssen der Transistoren 26 und 27 verbunden sind. An den miteinander verbundenen Basiselektroden der Transistoren 32 und 33 liegt eine Steuerspannung $U_3$, die aus der Ausgangsspannung der Steuerschaltung 11 bzw. des Verstärkers 14 abgeleitet ist. Ist die Spannung $U_3$ positiv im Vergleich zu der Spannung am Eingang der Transistoren 35, wird ein Teil des von der Gleichstromquelle 28 gelieferten Gleichstromes über den Widerstand 34 und die beiden Transistoren abgeführt, wobei er sich gleichmäßig auf die beiden Transistoren aufteilt. Es ergibt sich dann ein niedrigerer Wirkungsgrad des Demodulators bzw. eine niedrigere Schleifenverstärkung in der Schleife. Ist hingegen die Spannung $U_3$ negativer als die Gleichspannung an den Basisanschlüssen der Transistoren 26 und 27, wird praktisch kein Gleichstrom abgeführt und es ergibt sich ein höherer Demodulator-Wirkungsgrad bzw. eine höhere Schleifenverstärkung.

Grundsätzlich würde ein einziger Transistor zur Änderung des Demodulator-Wirkungsgrades genügen. Jedoch würde sich dann die Gleichspannung am Ausgang 30 ändern, was eine unerwünschte Arbeitspunktverschiebung in der Schleife zur Folge hätte. Diese wird dadurch unterbunden, daß die eine Hälfte des von der Gleichstromquelle 28 über den Transistor 33, dessen Kollektor mit dem Widerstand 29 bzw. dem Ausgang 30 verbunden ist, dem Ausgang des FM-Demodulators zugeführt wird, während die andere Hälfte des abgeleiteten Gleichstromes über den Kollektor des Transistors 32 abgeführt wird, der mit der positiven Speisespannung verbunden ist, so daß dieser Anteil für den Arbeitspunkt unwirksam ist. Die über den Transistor 33 und den Widerstand 29 geführte Hälfte des dem Gleichstromeingang des Demodulators entzogenen Gleichstroms, kompensiert gerade die Verringerung der über den Widerstand 29 geführten Kollektor-Gleichstroms der Transistoren 22 und 24, weil sich der von der Gleichstromquelle 28 über die Transistoren 26 und 27 zugeführte Gleichstrom gleichmäßig auf die vier Transistoren 21...24 aufteilt. Mit anderen Worten wird bei einer Verringerung des Demodulator-Wirkungsgrades der Strom über den Transistor 33 um den gleichen Betrag vergrößert, um den die Summe der Kollektor-Gleichströme der Transistoren 22 und 24 verringert wird, so daß die Gleichspannung am Ausgang 30 unabhängig vom Demodulator-Wirkungsgrad ist.

Das Dämpfungsglied wird bei der Schaltung nach Fig. 5 durch die Transistoren 32 und 33 sowie den Widerstand 34 gebildet. Über dieses Dämpfungsglied fließt lediglich ein Gleichstrom, so daß das Signal in der Schleife dadurch nicht verzerrt werden kann. Wenn der Gleichstrom-Arbeitspunkt am Ausgang der Steuerschaltung 11 sowie die Amplitude des davon gelieferten Signals $U_1$ richtig gewählt ist, können die Transistoren 32 und 33 auch unmittelbar durch die Steuerschaltung 11 angesteuert werden. In diesem Fall bestünde der zusätzliche Aufwand gegenüber der bekannten Schaltung nach Fig. 1 lediglich in den Transistoren 32 und 33 sowie dem Widerstand 34. Mit der Änderung der Zwischenfrequenz würde sich dabei der Demodulator-Wirkungsgrad nicht sprunghaft ändern, sondern mehr oder weniger gleitend und kontinuierlich. Doch würde dies die Funktion der Schaltung nicht beeinträchtigen.

Bisher wurde davon ausgegangen, daß die Steuerschaltung 11 durch einen Korrelator gebildet wird — ebenso wie bei der bekannten Schaltung nach der DE-A-30 32 701. Fig. 6a zeigt eine andere Ausführungsform einer solchen Steuerschaltung. Dabei wird die Ausgangsspannung des Demodulators $U_d$, deren Verlauf als Funktion der Differenz $f_s-f_o$ in Fig. 6b idealisiert dargestellt ist, dem Eingang einer Schaltung 40 zur Betragsbildung zugeführt, an deren Ausgang sich somit
das in Fig. 6c dargestellte Signal ergibt. Derartige
Schaltungen zur Betragsbildung eines FM-Demodulator-Ausgangssignals sind an sich aus der DE-
B-29 09 520 bekannt. Die Ausgangsspannung der
Schaltung 40 wird über einen Tiefpaß 41, dessen
Zeitkonstante vorzugsweise wesentlich größer ist
als die des Tiefpasses 7, dem Dämpfungsglied
entweder direkt oder über den Verstärker 14 (Fig.
3) zugeführt, bei dem die Referenzspannung $U_2$
am Eingang 15 geeignet gewählt ist.

## Patentansprüche

1. Empfängerschaltung mit einem Oszillator
(3), dessen Frequenz durch eine Spannung an
einem Steuereingang steuerbar ist, einer Mischstufe (2), die das Oszillatorsignal mit einem Antennensignal mischt und daraus ein Zwischenfrequenzsignal bildet, einem Frequenz-Spannungswandler (6), dem das Zwischenfrequenzsignal
zugeführt wird und aus dessen Ausgangssignal
ein tonfrequentes Signal mit einem Gleichanteil
für den Steuereingang des Oszillators abgeleitet
wird, und mit einer Steuerschaltung (11) zum
Erzeugen eines von der Abweichung der Frequenz des Zwischenfrequenzsignals von einem
Sollwert ($f_{zo}$) abhängigen Steuersignals, dadurch
gekennzeichnet, daß ein steuerbares Dämpfungsglied (13) zum Steuern der Schleifenverstärkung
in der den Oszillator (3), den Mischer (2) und den
Frequenz-Spannungswandler (6) enthaltenden
Schleife vorgesehen ist und daß die Dämpfung
des Dämpfungsgliedes durch die Steuerschaltung
so gesteuert ist, daß bei einer einen Mindestwert
überschreitenden Abweichung der Zwischenfrequenz ($f_z$) von der Sollfrequenz ($f_{zo}$) die Schleifenverstärkung auf einen niedrigeren Wert herabgesetzt wird, der größer ist als 1.
2. Empfängerschaltung nach Anspruch 1, dadurch gekennzeichne, daß die Steuerschaltung
(11) als Korrelator ausgebildet ist, wobei die
Korrelationszeit einer halben Periode des Sollwertes ($f_{zo}$) der Zwischenfrequenz entspricht.
3. Empfängerschaltung nach einem der vorhergehenden Ansprüche, dadurch gekennzeichnet,
daß eine Unterdrückungsschaltung (9) zum vollständigen oder teilweise Unterdrücken der Wiedergabe des aus dem Antennensignal abgeleiteten Nutzsignals vorgesehen ist und daß die
Steuerschaltung (11) außer der Dämpfungsschaltung (13) die Unterdrückungsschaltung (9) steuert
derart, daß die Unterdrückungsschaltung aktiviert
wird, wenn die Zwischenfrequenz ($f_z$) um einen
vorbestimmten Betrag von der Sollfrequenz ($f_{zo}$)
abweicht.
4. Empfängerschaltung nach einem der vorhergehenden Ansprüche, dadurch gekennzeichnet,
daß der Ausgang des Korrelators (11) mit einem
Eingang einer Vergleichsschaltung gekoppelt ist,
an deren anderem Eingang (15) eine Referenzspannung ($U_2$) anliegt, und daß der Ausgang der
Vergleichsschaltung mit dem Dämpfungsglied (13) verbunden ist.
5. Empfängerschaltung nach einem der vorhergehenden Ansprüche, dadurch gekennzeichnet,
daß der Frequenz-Spannungswandler (6) eine
Multiplizierschaltung (21...27) enthält, deren Wirkungsgrad durch die Steuerschaltung (11) gesteuert ist.
6. Empfängerschaltung nach Anspruch 5, dadurch gekennzeichnet, daß die Multiplizierschaltung (21...27) so ausgebildet ist, daß ihr Ausgangssignal sich gleichsinnig mit einem ihr zugeführten
Gleichstrom ändert und daß das Dämpfungsglied
(32, 33) so angeordnet und ausgebildet ist, daß es
einen Teil des Gleichstromes abführt.
7. Schaltungsanordnung nach Anspruch 6, wobei der Gleichstromarbeitspunkt am Ausgang der
Multiplizierschaltung durch den der Multiplizierschaltung zugeführten Gleichstrom bestimmt
wird, dadurch gekennzeichnet, daß der vom
Dämpfungsglied abgeleitete Teil des Gleichstromes zumindest teilweise dem Ausgang der Multiplizierschaltung zugeführt wird.

## Claims

1. A receiver circuit comprising an oscillator (3)
whose frequency is controllable by a voltage
applied to a control input, a mixer stage (2) which
mixes the oscillator signal with an aerial signal
and forms an intermediate frequency signal therefrom, a frequency-voltage converter (6) to which
the intermediate frequency signal is applied and
from whose output signal an audio-frequency
signal having a d. c. component for the control
input of the oscillator is derived, and a control
circuit (11) for producing a control signal which
depends on the deviation of the frequency of the
intermediate-frequency signal from a target mean
value ($f_{zo}$), characterized in that a controllable
attenuator (13) for controlling the loop gain in the
loop formed by the oscillator (3), the mixer (2) and
the frequency-voltage converter (6) is provided
and in that the attenuation of the attenuator is
controlled by the control circuit in such manner
that the loop gain is reduced to a lower value
which is larger than unity when the intermediate
frequency ($f_z$) deviates from the target mean
frequency ($f_{zo}$) by more than a minimum value.
2. A receiver circuit as claimed in Claim 1,
characterized in that the control circuit (11) is in
the form of a correlator, the correlation period
corresponding to half a period of the target mean
value ($f_{zo}$) of the intermediate frequency.
3. A receiver circuit as claimed in any of the
preceding Claims, characterized in that a muting
circuit (9) for fully or partially suppressing the
reproduction of the useful signal derived from the
aerial signal is provided and in that other than the
attenuator (13) the control circuit (11) controls
the muting circuit (9) such that the muting circuit
is activated when the intermediate frequency ($f_z$)
differs by a predetermined amount from the
target mean value ($f_{zo}$).
4. A receiver circuit as claimed in any of the preceding Claims, characterized in that the output of the correlator (11) is coupled to an input of a comparator circuit to whose other input (15) a reference voltage (U₂ is applied, and In that the output of the comparator circuit is connected to the attenuator (13).

5. A receiver circuit as claimed in any of the preceding Claims, characterized in that the frequencyvoltage converter (6) comprises a multiplying circuit (21...27) whose gain is controlled by the control circuit (11).

6. A receiver circuit as claimed in Claim 5, characterized in that the multiplying circuit (21,... 27) is constructed such that its output signal varies in the same sense with a direct current applied thereto and in that the attenuator (32, 33) is arranged and formed in such manner that it shunts a portion of the direct current.

7. A circuit arrangement as claimed in Claim 6, in which the direct current voltage level at the output of the multiplying circuit is determined by the direct current applied to the multiplying circuit, characterized in that the portion of the direct current shunted by the attenuator is applied at least partially to the output of the multiplying circuit.

## Revendications

1. Circuit récepteur comportant un oscillateur (3), dont la fréquence peut être commandée par une tension sur une entrée de commande, un étage mélangeur (2) qui mélange le signal d'oscillateur à un signal d'antenne et qui en forme un signal de fréquence intermédiaire, un convertisseur de fréquence-tension (6) auquel le signal de fréquence intermédiaire est appliqué et du signal de sortie duquel est dérivé un signal à fréquence audio comportant une fraction continue pour l'entrée de commande de l'oscillateur, et un circuit de commande (11) pour produire un signal de commande dépendant de l'écart entre la fréquence du signal à fréquence intermédiaire et une valeur de consigne ($f_{zo}$), caractérisé en ce qu'un élément d'amortissement pilotable (13), est prévu pour commander l'amplification de boucle dans la boucle contenant l'oscillateur (3), le mélangeur (2) et le convertisseur de fréquence-tension (6) et que l'amortissement de l'élément d'amortissement est commandé par le circuit de commande d'une manière telle que, dans le cas d'un écart excédant une valeur minimum entre la fréquence intermédiaire ($f_z$) et la fréquence de consigne ($f_{zo}$), l'amplification de boucle est ramenée à une valeur inférieure qui est supérieure à 1.

2. Circuit récepteur suivant la revendication 1, caractérisé en ce que le circuit de commande (11) a la forme d'un corrélateur, le temps de corrélation correspondant à une demi-période de la valeur de consigne ($f_{zo}$) de la fréquence intermédiaire.

3. Circuit récepteur suivant l'une quelconque des revendications précédentes, caractérisé en ce qu'un circuit de suppression (9) est prévu pour supprimer complètement ou partiellement la reproduction du signal utile dérivé du signal d'antenne et que le circuit de commande (11), en plus de l'élément d'amortissement (13), commande le circuit de suppression (9) d'une manière telle que le circuit de suppression soit activé lorsque la fréquence intermédiaire ($f_z$) s'écarte d'une valeur absolue prédéterminée de la valeur de consigne ($f_{zo}$).

4. Circuit récepteur suivant l'une quelconque des revendications précédentes, caractérisé en ce que la sortie du corrélateur (11) est couplée à une entrée d'un circuit comparateur dont l'autre entrée (15) reçoit une tension de référence ($U_2$) et que la sortie du circuit comparateur est connectée à l'élément d'amortissement (13).

5. Circuit récepteur suivant l'une quelconque des revendications précédentes, caractérisé en ce que le convertisseur de fréquence-tension (6) contient un circuit multiplicateur (21...27) dont l'efficacité est régie par le circuit de commande (11).

6. Circuit récepteur suivant la revendication 5, caractérisé en ce que le circuit multiplicateur (21...27) est conçu d'une manière telle que son signal de sortie varie dans le même sens qu'un courant continu qui lui est appliqué et que l'élément d'amortissement (32, 33) est agencé et conçu d'une manière telle qu'il évacue une fraction du courant continu.

7. Montage de circuit suivant la revendication 6, dans lequel le point de fonctionnement en courant continu sur la sortie du circuit multiplicateur est déterminé par le courant continu appliqué au circuit multiplicateur, caractérisé en ce que la fraction du courant continu dérivée de l'élément d'amortissement est appliquée au moins pour partie à la sortie du circuit multiplicateur.

Fig. 1

Fig. 2a

Fig. 2b

Fig. 2c

Fig. 2d

Fig. 2e

Fig. 3

Fig. 5

Fig. 6a

Fig. 6b

Fig. 6c

Fig. 4a

Fig. 4b

Fig. 4c

Fig. 4d

Fig. 4e

Fig. 4f

3